(19) Europäisches Patentamt
European Patent Office
Office européen des brevets

(11) **EP 2 843 434 A2**

(12) **EUROPEAN PATENT APPLICATION**

(43) Date of publication:
04.03.2015 Bulletin 2015/10

(51) Int Cl.:
*G01R 33/028* (2006.01)  *G01R 33/00* (2006.01)

(21) Application number: 14173999.5

(22) Date of filing: 25.06.2014

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME

(30) Priority: 15.07.2013 US 201313942167

(71) Applicant: Honeywell International Inc.
Morristown, NJ 07962-2245 (US)

(72) Inventors:
• Elgersma, Michael Ray
Morristown, NJ New Jersey 07962-2245 (US)
• Bageshwar, Vibhor L.
Morristown, NJ New Jersey 07962-2245 (US)
• Kreichauf, Ruth Dagmar
Morristown, NJ New Jersey 07962-2245 (US)

(74) Representative: Houghton, Mark Phillip
Patent Outsourcing Limited
1 King Street
Bakewell, Derbyshire DE45 1DZ (GB)

(54) **System and method for magnetometer calibration and compensation**

(57) A system comprises an inertial measurement unit comprising one or more gyroscopes configured to measure angular velocity about a respective one of three independent axes and one or more accelerometers configured to measure specific force along a respective one of the three independent axes; a magnetometer configured to measure strength of a local magnetic field along each of the three independent axes; and a processing device coupled to the inertial measurement unit and the magnetometer; the processing device configured to compute kinematic state data for the system based on measurements received from the magnetometer and the inertial measurement unit. The processing device is further configured to calculate magnetometer measurement calibration parameters using a first technique when position data is unavailable and to calculate magnetometer measurement calibration parameters using a second technique when position data is available.

FIG. 2

EP 2 843 434 A2

**Description**

BACKGROUND

A magnetic compass can be used to determine a vehicle's heading angle or as part of a vector matching algorithm to determine a vehicles' attitude (roll and pitch angles) and heading angle. Even if the vehicle is tilted by some values of the pitch and roll angles, a three-axis magnetometer measuring all three components of Earth's magnetic field can still be used to determine the heading angle of the vehicle. However, the measurements of a magnetometer can be distorted by various types of magnetic disturbances near the magnetometer. Some types of magnetic disturbances, such as ferromagnetic materials, are referred to as "hard iron" biases and can add to the magnetic field measured by a magnetometer. Other types of magnetic disturbances referred to as "soft iron" biases can vary the magnitude and direction of the magnetic field near a magnetometer.

SUMMARY

In one embodiment a system is provided. The system comprises an inertial measurement unit comprising one or more gyroscopes configured to measure angular velocity about a respective one of three independent axes and one or more accelerometers configured to measure specific force along a respective one of the three independent axes; a magnetometer configured to measure strength of a local magnetic field along each of the three independent axes; and a processing device coupled to the inertial measurement unit and the magnetometer; the processing device configured to compute kinematic state data for the system based on measurements received from the magnetometer and the inertial measurement unit. The processing device is further configured to calculate magnetometer measurement calibration parameters using a first technique when position data is unavailable and to calculate magnetometer measurement calibration parameters using a second technique when position data is available.

DRAWINGS

Understanding that the drawings depict only exemplary embodiments and are not therefore to be considered limiting in scope, the exemplary embodiments will be described with additional specificity and detail through the use of the accompanying drawings, in which:

Figure 1 is a block diagram of one embodiment of a system for magnetometer calibration and compensation.

Figure 2 is a flow chart depicting one embodiment of an exemplary method of calibrating magnetometer measurements.

Figure 3 is a flow chart depicting one embodiment of an exemplary method of computing calibration parameters when position information is available.

Figure 4 is a flow chart depicting one embodiment of an exemplary method of computing calibration parameters when position information is unavailable.

Figure 5 is a flow chart depicting one embodiment of an exemplary method of compensating the magnetometer measurements.

Figure 6 is a flow chart depicting one embodiment of another exemplary method of compensating the magnetometer measurements.

In accordance with common practice, the various described features are not drawn to scale but are drawn to emphasize specific features relevant to the exemplary embodiments.

DETAILED DESCRIPTION

In the following detailed description, reference is made to the accompanying drawings that form a part hereof, and in which is shown by way of illustration specific illustrative embodiments. However, it is to be understood that other embodiments may be utilized and that logical, mechanical, and electrical changes may be made. Furthermore, the methods presented in the drawing figures and the specification are not to be construed as limiting the order in which the individual steps may be performed. The following detailed description is, therefore, not to be taken in a limiting sense.

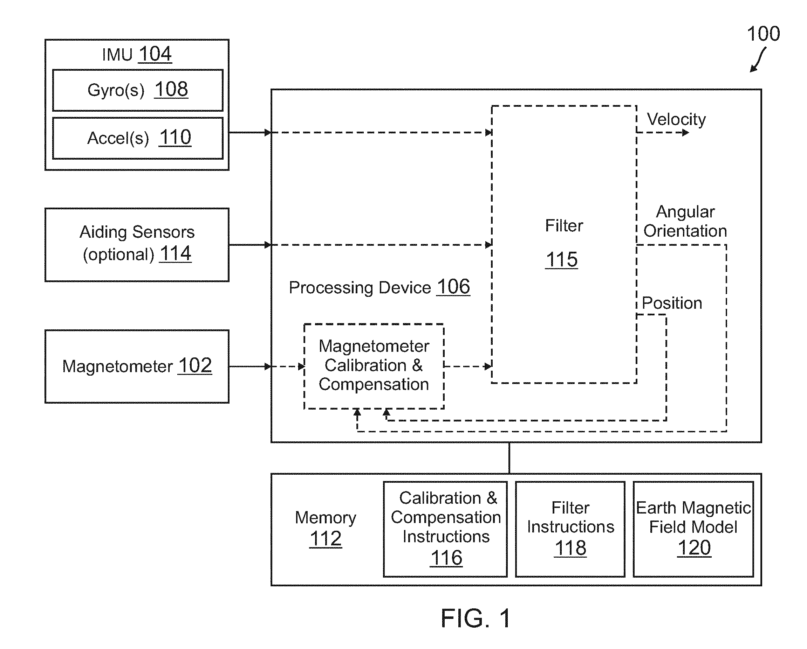

Figure 1 is a block diagram of one embodiment of a system 100 for magnetometer calibration and compensation. System 100 includes a three-axis magnetometer 102, an inertial measurement unit 104, and a processing device 106. The inertial measurement unit (IMU) 104 comprises one or more rate gyroscopes 108 and one or more accelerometers 110. Each rate gyroscope 108 is configured to measure angular velocity about a respective axis. Similarly, each accelerometer 110 is configured to measure specific force along a respective axis. In some embodiments, the IMU 104 includes a three-axis gyroscope 108 for measuring angular velocity along each of three independent axes and a three-axis accelerometer 110 for measuring specific force along each of the three independent axes. The three-axis magnetometer 102 measures the strength of the local magnetic field along three independent axes. In some embodiments, the three independent axes are orthogonal. In other embodiments, the three independent axes are not orthogonal, but are still independent of one another.

In some embodiments, the system 100 also optionally includes one or more aiding sensors 114. Aiding sensors 114 provide additional measurements used to compute the kinematic state of the system 100. Some examples of aiding sensors include, but are not limited to, altimeters, cameras, global navigation satellite system (GNSS) receivers, Light Detection and Ranging (LIDAR) sensors, Radio Detection and Ranging (RADAR) sensors, star trackers, Sun sensors, and true airspeed sensors. Such exemplary aiding sensors are known to one of skill in the art and are not described in more detail herein.

The processing device 106 can include a central processing unit (CPU), microcontroller, microprocessor (e.g., a digital signal processor (DSP)), field programmable gate array (FPGA), application specific integrated circuit (ASIC), and other processing devices. The memory device 112 can include tangible media such as magnetic or optical media. For example, tangible media can include a conventional hard disk, compact disk (e.g., read only or re-writable), volatile or non-volatile media such as random access memory (RAM) including, but not limited to, synchronous dynamic random access memory (SDRAM), double data rate (DDR) RAM, RAMBUS dynamic RAM (RDRAM), static RAM (SRAM), etc.), read only memory (ROM), electrically erasable programmable ROM (EEPROM), and flash memory, etc. For example, in this embodiment, the processing device 106 is implemented as a central processing unit which includes or functions with software programs, firmware or other computer readable instructions stored on memory device 112 for carrying out various methods, process tasks, calculations, and control functions, used for the magnetometer calibration and compensation. For example, stored on memory device 112 in this embodiment are calibration and compensation instructions 116 and filter instructions 118, which are described in more detail below. In addition, in this embodiment memory device 112 includes an Earth Magnetic Field Model (EMFM) 120.

In operation, the IMU 104, the magnetometer 102, and optionally the one or more aiding sensors 114 provide respective measurements to the processing device 106. The processing device 106 executes filter instructions 118 to compute kinematic state data for the system 100, such as velocity, angular orientation, and/or position based on the received measurements. For example, the filter instructions 118 can implement a filter 115 such as a Kalman filter. Operation of a Kalman filter is known to one of skill in the art and not described in more detail herein.

The processing device 106 executes the calibration and compensation instructions 116 to calculate magnetometer compensation parameters based on kinematic state data and to compensate the magnetometer measurements based on the calculated parameters. For purposes of illustration, Figure 1 represents data flow in the operations performed by the processing device 106 as dashed lines within the processing device 106. As shown in Figure 1, the processing device computes kinematic state data based on the measurements received from the IMU 104, the magnetometer 102, and optionally one or more aiding sources 114. The processing device then calibrates and compensates the magnetometer measurements based on the kinematic state data. In some embodiments, position data is not available in the kinematic state data. In such embodiments, the processing device 106 is still able to calculate calibration parameters to calibrate and compensate the magnetometer measurements.

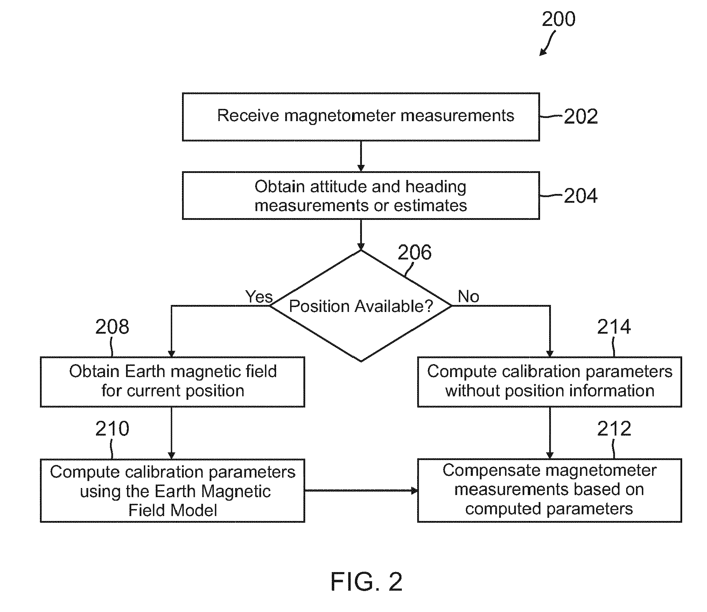

In particular, additional details regarding the magnetometer calibration and compensation are discussed below with respect to Figures 2 - 5. The methods described in relation to Figures 2 - 5 can be implemented by the processing device 106 executing calibration and compensation instructions 116. However, it is to be understood that it is not necessary for the processing device 106 to perform each of the steps in the methods presented in Figures 2-5. For example, method 400 discusses formulating a batch model at block 402 and rewriting the model in matrix form at block 404. Such steps can be configured *a priori* and need not be performed as part of the functions performed by the processing device 106 when executing the calibration and compensation instructions 116.

Figure 2 is a flow chart depicting an exemplary method 200 of calibrating magnetometer measurements. At block 202, magnetometer measurements are received at the processing device 106 from the magnetometer 102. At block 204, attitude and heading estimates or measurements are obtained. For example, the processing device 106 can compute the attitude and heading based on data received from the IMU 104, magnetometer 102, and/or one or more optional aiding sensors 114. At block 206, it is determined if position data is available. Position data indicates the approximate current geographic location of the system 100. For example, in some embodiments, the processing device 106 is able to calculate the current geographic location or position data based on data received from one or more of the IMU 104, magnetometer 102, and optional aiding sensors 114. However, in other embodiments, insufficient data is available for determining the geographic location.

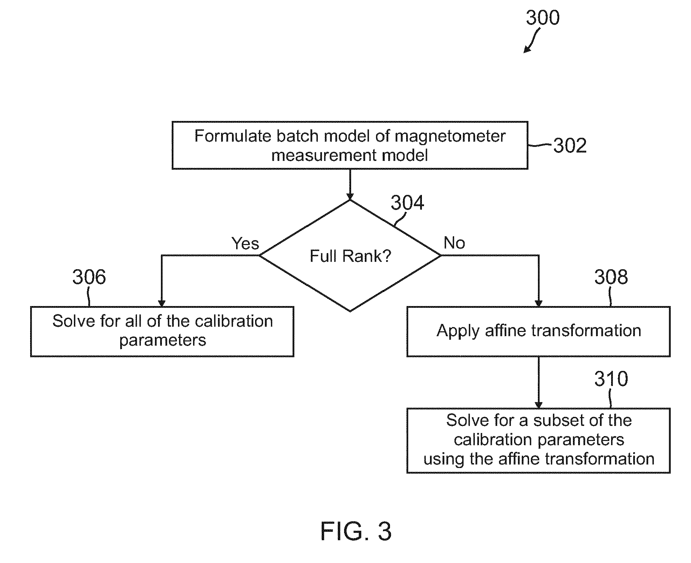

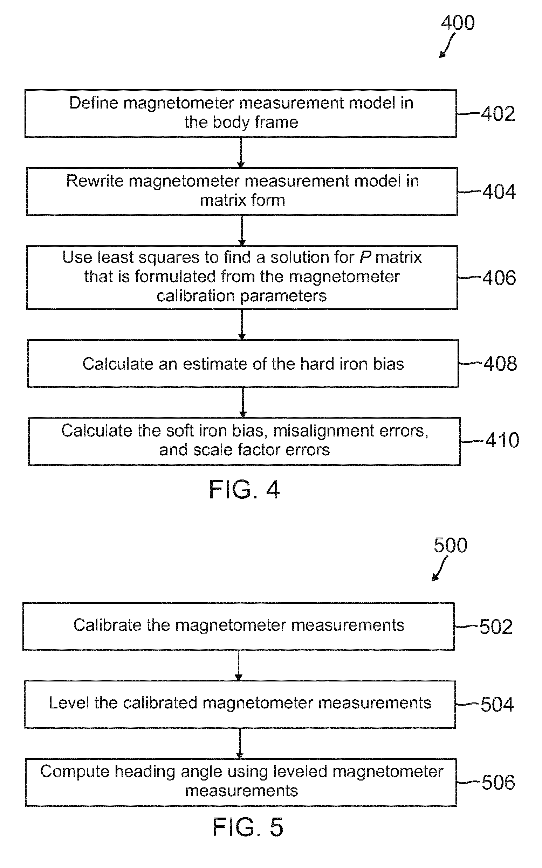

If position data is available at block 206, reference magnetic field values are obtained at block 208 from an Earth magnetic field model based on the position data. One such model of the Earth's magnetic field, known as the International Geomagnetic Reference Field (IGRF), is made publicly available by the National Oceanic and Atmospheric Administration (NOAA), for example. At block 210, calibration parameters are computed based on the reference magnetic field values from the EMFM and on the measured magnetic field values from the magnetometer 102. An exemplary method of computing calibration parameters when position information is available is described in more detail below with respect to Figure 3. At block 212, the magnetometer measurements are compensated based on the computed parameters. An exemplary method of compensating the magnetometer measurements is described in more detail below with respect to Figure 5.

If position data is not available at block 206, calibration parameters are computed at block 214 based on the magnetometer measurements without the use of position information. For example, reference magnetic field values are not obtained as position data is unavailable. Thus, the calibration parameters are computed without the reference magnetic field values. An exemplary method of computing the calibration parameters without position data is described in more detail below. After computing the calibration parameters, the magnetometer measurements are compensated at block 212 as described in more detail below.

Figure 3 is a flow chart depicting a method 300 of computing calibration parameters when position information is available. Method 300 can be used to implement the computation performed at block 210 in Method 200. At block 302, a batch measurement model is formulated. For example, a magnetometer measurement model can be stated as:

$$\text{Eq. 1} \quad C_{bm} m_{m,k}^m = A_{MC,k} m_{t,k}^b + C_{bm} b_{m,k}^m + C_{bm} n_{m,k}^m$$

In equation 1 above, $C_{bm}$ is the direction cosine matrix from the magnetometer measurement frame to the body frame of the vehicle in which the system resides and $m_{m,k}^m$ is the magnetometer measurement vector for a time index $k$. The superscript $m$ indicates that the measurement vector is resolved in the magnetometer measurement frame and the subscript $m$ indicates that it is a measurement vector. Additionally, the quantity $A_{MC,k}$ is a 3x3 matrix representing the soft iron bias, misalignment errors, $b$ and scale factor errors for a time index $k$; $m_{t,k}^b$ is a reference or true magnetic field vector resolved in the body frame of the vehicle for the time index $k$; $b_{m,k}^m$ is a hard iron bias vector resolved in the magnetometer measurement frame for the time index $k$; and $n_{m,k}^m$ is noise measurement vector resolved in the magnetometer measurement frame for the time index $k$. As used herein the magnetometer measurement frame refers to the orientation of the magnetometer measurement axes. Similarly, the body frame refers to the orientation of the vehicle in which the system 100 is located. The navigation frame, discussed below, is a frame independent of the vehicle and magnetometer orientation, such as the Earth-Centered, Earth-Fixed frame or local-level frame known to one of skill in the art.

The magnetometer measurement model can also be written as:

$$\text{Eq. 2} \quad C_{bm} m_{m,k}^m = A_{MC,k} C_{bN,k} m_{t,k}^N + C_{bm} b_{m,k}^m + C_{bm} n_{m,k}^m$$

In equation 2, $C_{bN,k}$ is the direction cosine matrix from the navigation frame to the body frame; and $m_{t,k}^N$ is the reference or true magnetic field vector resolved in the navigation frame. The hard iron bias vector, $b_m$, represents magnetic fields typically generated by ferromagnetic materials with permanent magnetic fields. In this example, the hard iron bias is assumed to be a time-invariant, additive error. The soft iron bias matrix, $A_{si}$, represents magnetic fields typically generated by materials excited by externally generated fields or directly from the externally generated fields themselves. Scale factor error matrix, $A_{sf}$, represents errors due to sensitivity to applied magnetic fields along a measurement axis. Misalignment error matrix, $A_m$, represent errors due to misalignment of the measurement axes with the intended mounting angular orientation. Thus, the matrix, $A_{MC}$, represents a combination of the soft iron bias, scale factor errors, and misalignment errors (i.e. $A_{MC} = A_{sf}A_{sf}A_m$). Thus, the matrix $A_{MC}$ can be written in matrix form as:

$$A_{MC} = \begin{bmatrix} A_{11} & A_{12} & A_{13} \\ A_{21} & A_{22} & A_{23} \\ A_{31} & A_{32} & A_{33} \end{bmatrix} = \begin{bmatrix} A_{*1} & A_{*2} & A_{*3} \end{bmatrix},$$

where $A_{*1}, A_{*2}, A_{*3}$ are the columns of $A_{MC}$.

Similarly, the quantities $C_{bN,k}m_{t,k}^{N}$, $C_{bm}b_{m,k}^{m}$, and $m_{m,k}^{b}$ can be written as follows:

$$C_{bN,k}m_{t,k}^{N} = \begin{bmatrix} M_{1,k} & M_{2,k} & M_{3,k} \end{bmatrix}^{T}$$

$$C_{bm}b_{m,k}^{m} = \begin{bmatrix} b_{1} & b_{2} & b_{3} \end{bmatrix}^{T}$$

$$m_{m,k}^{b} = \begin{bmatrix} m_{1,k} & m_{2,k} & m_{3,k} \end{bmatrix}^{T}$$

In addition, in this exemplary embodiment, it is assumed that the noise vector is zero-mean, Gaussian, white noise and that the magnetometer measurement axes are aligned with the vehicles body axes (e.g. $C_{bm} = I$). The local true or reference magnetic field vector is selected from an EMFM based on input position data, as discussed above. The direction cosine matrix, $C_{bN}$, can be calculated from roll, pitch, and heading angles from the data received from either the IMU 104 or filter 115, for example. Based on the above assumptions, equation 1 can be rewritten as:

$$\text{Eq. 3} \quad m_{m,k}^{b} = A_{MC}C_{bN,k}m_{t,k}^{N} + b_{m}^{b} + n_{m,k}^{b}$$

The measurement model can then be rewritten in batch form as shown in equation 4 below. As used herein, the notation $E\{\}$ indicates an expected value of the quantity surrounded by the brackets.

Eq. 4

$$\begin{bmatrix} m_{1,1} & m_{2,1} & m_{3,1} \\ \vdots & \vdots & \vdots \\ m_{1,N} & m_{2,N} & m_{3,N} \end{bmatrix} = \begin{bmatrix} E\{M_{1,1}\} & E\{M_{2,1}\} & E\{M_{3,1}\} & 1 \\ \vdots & \vdots & \vdots & \vdots \\ E\{M_{1,N}\} & E\{M_{2,N}\} & E\{M_{3,N}\} & 1 \end{bmatrix} \begin{bmatrix} E\{A_{*1}\} & E\{A_{*2}\} & E\{A_{*3}\} \\ E\{b_{1}\} & E\{b_{2}\} & E\{b_{3}\} \end{bmatrix}$$

$$Y = MX$$

In equation 4, $Y$ is the Nx3 magnetometer measurement matrix, M is a Nx4 matrix of estimated magnetic field values based on the EMFM, and X is a 4x3 matrix representing values of the $A_{MC}$ matrix and the hard iron bias vector, $b_m$. Thus, solving for the values of the X matrix provides 12 calibration parameters for calibrating the magnetometer measurements.

After formulating the batch measurement model at block 302, a rank test is performed at block 304. In particular, the batch measurement model equation can be rewritten as follows:

$$Y = MX$$

$$M^T Y = M^T M X$$

$$X = \left( M^T M \right)^{-1} M^T Y$$

$$X = M^+ Y$$

where $M^T$ is the transpose matrix of $M$ and $M^+$ is the pseudoinverse of $M$.

Thus, the solution depends on the rank of $M$. For example, if M has full column rank, then the pseudoinverse $M^+$ exists and all 12 magnetometer calibration parameters can be computed. For example, full column rank indicates that the vehicle has traveled a selected three-dimensional (3D) trajectory which involves sufficient maneuvers to observe all magnetometer modes or calibration parameters. If $M$ does not have full column rank, then the pseudoinverse $M^+$ does not exist. For example, if the selected vehicle trajectories do not permit observing all magnetometer modes or calibration parameters, then $M$ will not have full rank.

However, the embodiments described herein permit the calculation of a subset of parameters even if $M$ does not have full rank. Thus, the magnetometer measurements may still be calibrated even when all magnetometer modes have not been observed. Thus, calibration according to the embodiments described herein requires a reduced amount of maneuvers during calibration as compared to conventional calibration systems. For example, an initial calibration can be done using only heading maneuvers, such as can be performed by an aircraft, for example, while it is taxiing on the ground. Afterward, a few additional 3D maneuvers in the air can complete the calibration process.

To perform the rank test at block 304, a matrix decomposition of $M$ is performed. For example, as described herein, a singular value decomposition is performed. However, it is to be understood that, in other embodiments, other matrix decomposition techniques known to one of skill in the art can be used instead of a singular value decomposition. As known to one of skill in the art, the singular value decomposition can be written as:

$$\text{Eq. 5} \quad M = U \Sigma V^T$$

The diagonal values of diagonal matrix $\Sigma$ are the singular values of $M$. Each of the diagonal values is compared to a pre-determined threshold, $\varepsilon$. Thus, the rank is the number of singular values greater than the user-defined threshold $\varepsilon$. In some embodiments, the user-defined threshold is set equal to the magnitude of the unknown varying magnetic disturbances, due to things like varying magnetic fields from electrical devices, or variable amounts of iron in the soil over which the magnetometer is moving, as established from *a priori* experiments for example. If each of the diagonal values is greater than the threshold, then the matrix $M$ has full column rank. In particular, in this example, if the rank of the matrix $M$ is equal to 12 at block 304, then the processing device solves for all 12 parameters of a calibration matrix $X$ at block 306 using the singular value decomposition of $M$ and the magnetometer measurements in matrix $Y$ (i.e. $X = V\Sigma^{-1}U^T Y$).

If the rank of the matrix M is less than 12 at block 304, then the processing device applies an affine transformation to X, at block 308, that selects a linear combination of magnetometer calibration parameters. For example, the affine transformation can be expressed as:

$$\text{Eq. 6} \quad X = T_1 X_A + T_2$$

For a two dimensional ground application, for example, an exemplary affine transformation can be written as:

$$X = \begin{bmatrix} 1 & 0 & 0 & 0 \\ 0 & 0 & 0 & 0 \\ 0 & 0 & 0 & 0 \\ 0 & 0 & 0 & 0 \\ 0 & 1 & 0 & 0 \\ 0 & 0 & 0 & 0 \\ 0 & 0 & 0 & 0 \\ 0 & 0 & 0 & 0 \\ 0 & 0 & 0 & 0 \\ 0 & 0 & 1 & 0 \\ 0 & 0 & 0 & 1 \\ 0 & 0 & 0 & 0 \end{bmatrix} \begin{bmatrix} E\{A_{1,1}\} \\ E\{A_{2,2}\} \\ E\{b_1\} \\ E\{b_2\} \end{bmatrix} + \begin{bmatrix} 0 \\ 0 \\ 0 \\ 0 \\ 0 \\ 0 \\ 0 \\ 0 \\ 1 \\ 0 \\ 0 \\ 0 \end{bmatrix}$$

At block 310, the processing device solves for a subset of the calibration parameters using the affine transformation. For example, by substituting in the affine transformation, the batch measurement model can be rewritten as:

$$\text{Eq. 7}\quad Y - MT_2 = MT_1 X_A$$

The singular value decomposition of $MT_1$ can be written as:

$$MT_1 = U_r \Sigma_r V_r^T$$

Solving for $X_A$ using the singular value decomposition yields:

$$E\{X_A\} = V_r \Sigma_r^{-1} U_r^T \left( Y - MT_2 \right)$$

After solving for $X_A$, the processing device solves for $X$ using the affine transformation and values of $X_A$. Thus, method 300 provides computed values for a subset of the calibration parameters whether or not all magnetometer modes have been observed through sufficient maneuvers.

Figure 4 is a flow chart of a method 400 of computing calibration parameters when position data is not available. Since the position data is unknown, the constant magnetic field vector resolved in Earth coordinates, $m_{t,k}^N$, is unknown and consequently, the $M_{i,j}$ in equation 4 are unknown. Techniques for eliminating those unknowns, then solving for the remaining variables are the basis of method 400. Method 400 is based on the following geometric reasoning: without magnetometer measurement errors, the magnetometer measurement unit vector in three-dimensional space maps out a unit sphere. However, with magnetometer measurement errors, the magnetometer measurement unit vector maps out an ellipsoid biased from the origin of the unit sphere. In two-dimensional space without magnetometer measurement errors, the magnetometer measurement unit vector maps out a unit circle. However, with magnetometer measurement errors, the magnetometer measurement unit vector maps out a unit ellipse biased from the origin of the unit circle. Hence, the calibration parameters for three-dimensional space are the parameters that transform the ellipsoid to a unit sphere. Similarly, the calibration parameters for two-dimensional space are the parameters that transform the ellipse to a unit circle.

Method 400 presents one exemplary technique of computing such parameters and can be used to implement the computation performed at block 214 in Method 200. At block 402, the magnetometer measurement model is defined in the body frame, as shown in equation 8, for example.

$$\text{Eq. 8} \quad m_{m,k}^{b} = \left\| m_{t}^{N} \right\| A_{MC} C_{bN,k} \frac{m_{t}^{N}}{\left\| m_{t}^{N} \right\|} + b_{m}^{b} + n_{m,k}^{b}$$

Equation 8 is similar to Equation 3 above, with the addition of $\left\| m_{t}^{N} \right\|$, which represents the magnitude of the local Earth magnetic field vector in the navigation frame. In addition, although the local Earth magnetic field vector is unknown, it is assumed that it is constant at the respective location of the magnetometer. It is also assumed in this example that the matrix $A_{MC}$ is non-singular and that the estimated direction cosine matrix $C_{bN,k}$ is orthonormal (e.g. it is assumed that equation 9 is true).

$$\text{Eq. 9} \quad E\left\{ C_{bN,k}^{T} \right\} E\left\{ C_{bN,k} \right\} = I \quad \forall k$$

At block 404, the magnetometer measurement model is rewritten in a matrix form to separate known quantities from unknown quantities. For example, equation 8 can be approximated as:

$$\text{Eq. 10} \quad m_{m,k}^{b} \approx E\left\{ \left\| m_{t}^{N} \right\| A_{MC} \right\} E\left\{ C_{bN,k} \right\} E\left\{ \frac{m_{t}^{N}}{\left\| m_{t}^{N} \right\|} \right\} + E\left\{ b_{m}^{b} \right\}$$

Equation 10 can then be rearranged as shown in equation 11.

$$\text{Eq. 11} \quad E\left\{ \left( \left\| m_{t}^{N} \right\| A_{MC} \right)^{-1} \right\} \left( m_{m,k}^{b} - E\left\{ b_{m}^{b} \right\} \right) = E\left\{ C_{bN,k} \right\} E\left\{ \frac{m_{t}^{N}}{\left\| m_{t}^{N} \right\|} \right\}$$

Multiplying each side of equation 11 by its transpose eliminates the unknown magnetic field unit vector, since $E\left\{ C_{bN,k} \right\} E\left\{ \frac{m_{t}^{N}}{\left\| m_{t}^{N} \right\|} \right\}$ times its transpose is equal to one or the identity matrix. This results in equation 12a below.

$$\text{Eq. 12a} \quad \left( m_{m,k}^{b} - E\left\{ b_{m}^{b} \right\} \right)^{T} E\left\{ \left( \left\| m_{t}^{N} \right\| A_{MC} \right)^{-T} \right\} E\left\{ \left( \left\| m_{t}^{N} \right\| A_{MC} \right)^{-1} \right\} \left( m_{m,k}^{b} - E\left\{ b_{m}^{b} \right\} \right) = 1$$

Multiplying Eq. 12a by $\left\| m_{t}^{N} \right\|^{2}$ yields equation 12b.

$$\text{Eq. 12b } \left(m_{m,k}^b - E\left\{b_m^b\right\}\right)^T E\left\{(A_{MC})^{-T}\right\} E\left\{(A_{MC})^{-1}\right\}\left(m_{m,k}^b - E\left\{b_m^b\right\}\right) = \left\|m_t^N\right\|^2$$

Equation 12b can be rewritten as equation 13.

$$\text{Eq. 13 } \left(m_{m,k}^b - E\left\{b_m^b\right\}\right)^T Q\left(m_{m,k}^b - E\left\{b_m^b\right\}\right) = \left\|m_t^N\right\|^2$$

In equation 13, $Q$ is a matrix representing the quantity $E\{(A_{MC})^{-T}\}E\{(A_{MC})^{-1}\}$. Equation 13 can then be rewritten in matrix form to separate the known quantities from the unknown quantities as shown in equation 14.

$$\text{Eq. 14}$$

$$0 = \begin{bmatrix} m_{m,k}^b \\ 1 \end{bmatrix}^T \begin{bmatrix} Q & -QE\left\{b_m^b\right\} \\ -E\left\{b_m^{bT}\right\}Q & E\left\{b_m^{bT}\right\}QE\left\{b_m^b\right\} - \left\|m_t^N\right\|^2 \end{bmatrix} \begin{bmatrix} m_{m,k}^b \\ 1 \end{bmatrix} = \begin{bmatrix} m_{m,k}^b \\ 1 \end{bmatrix}^T P \begin{bmatrix} m_{m,k}^b \\ 1 \end{bmatrix}$$

The matrix P is a 4x4 matrix representing the unknown magnetometer calibration parameters as shown below.

$$P = \begin{bmatrix} p_{11} & p_{12} & p_{13} & p_{14} \\ p_{12} & p_{22} & p_{23} & p_{24} \\ p_{13} & p_{23} & p_{33} & p_{34} \\ p_{14} & p_{24} & p_{34} & p_{44} \end{bmatrix} = \begin{bmatrix} Q & -QE\left\{b_m^b\right\} \\ -E\left\{b_m^{bT}\right\}Q & E\left\{b_m^{bT}\right\}QE\left\{b_m^b\right\} - \left\|m_t^N\right\|^2 \end{bmatrix}$$

Thus, $Q$ is a 3x3 matrix represented by the elements $P(1:3, 1:3)$. Additionally, the quantity $-QE\left\{b_m^b\right\}$ is a vector equal to the first three elements in the 4th column of $P$ (i.e. $P(1:3, 4)$). The quantity $-E\left\{b_m^{bT}\right\}Q$ is a vector equal to the first three elements of the 4th row of $P$ (i.e. $P(4, 1:3)$). The quantity $E\left\{b_m^{bT}\right\}QE\left\{b_m^b\right\} - \left\|m_t^N\right\|^2$ is a scalar equal to the 4th element of the 4th row in the matrix P (i.e. $P(4:4)$).

At block 406, a solution for P is found using a least squares approach. For example, P can be rewritten in vector form as shown below.

$$\text{Eq. 15 } \begin{bmatrix} Z_1 \\ \vdots \\ Z_N \end{bmatrix} P_{vec} = \begin{bmatrix} 0 \\ \vdots \\ 0 \end{bmatrix} \text{ where } ZP_{vec} = 0$$

The matrix Z is an Nx10 matrix and is singular. Each *kth* row of the matrix Z can be represented as

$$Z_k = \begin{bmatrix} m_{1,k}^2 & 2m_{1,k}m_{2,k} & 2m_{1,k}m_{3,k} & 2m_{1,k} & m_{2,k}^2 & 2m_{2,k}m_{3,k} & 2m_{2,k} & m_{3,k}^2 & 2m_{3,k} & 1 \end{bmatrix}$$

Similarly, the vector $P_{vec}$ can be represented as

$$P_{vec} = \begin{bmatrix} P_{11} & P_{12} & P_{13} & P_{14} & P_{22} & P_{23} & P_{24} & P_{33} & P_{34} & P_{44} \end{bmatrix}^T$$

The singular value decomposition of Z is represented as $Z = U_Z \Sigma_Z V_Z^T$, where $U_Z$ is a NxN matrix, $\Sigma_Z$ is an Nx10 matrix, and $V_Z$ is a 10x10 matrix, as understood by one of skill in the art. The vector $P_{vec}$ is equal to the tenth column of the $V_Z$ matrix (i.e. $P_{vec} = V_Z(:,10)$). Thus, performing the singular value decomposition of Z provides the values of $P_{vec}$. The values of $P_{vec}$ can then be used to fill in the entries of the P matrix which allows for the computation of an estimate of the hard iron

bias $E\left\{b_m^b\right\}$ at block 408. In particular, as stated above, the matrix Q is equal to $P(1:3,1:3))$ and $-QE\left\{b_m^b\right\}$ is equal to $P(1:3,4)$. Therefore, equation 16 can be derived from the above information to find an estimate of the hard iron bias, $E\left\{b_m^b\right\}$, in terms of the matrix P.

$$\text{Eq. 16} \quad E\left\{b_m^b\right\} = -\left[P(1:3,1:3)\right]^{-1} P(1:3,4)$$

Thus, the hard iron bias is calculated based on a singular value decomposition of the matrix Z which contains entries based on the magnetometer measurements. After calculating estimated values of $b_m^b$, those values are used together with the magnetometer measurements to solve for an estimate of the 3x3 matrix which represents the soft iron bias, misalignment errors, and scale factor errors (i.e. $E\{A_{MC}\}$), at block 410. In particular, a singular value decomposition of $E\{A_{MC}\}$ can be expressed as $\beta U_A \Sigma_A V_A^T$. Substituting the singular value decomposition for $E\{A_{MC}\}$ in an equation for the matrix Q results in equation 17.

$$\text{Eq. 17} \quad Q = \left(\beta U_A \Sigma_A V_A^T\right)^{-T} \left(\beta U_A \Sigma_A V_A^T\right)^{-1} = \beta^{-2} U_A \Sigma_A^{-T} \Sigma_A^{-1} U_A^T = P(1:3,1:3)$$

Since the matrix $A_{MC}$ cannot be uniquely determined from Q alone, equations 18-20 are identified to solve for $V_A$.

$$\text{Eq. 18} \quad E\left\{C_{bN,k}\right\} E\left\{m_t^N\right\} = E\left\{(A_{MC})^{-1}\right\} \left(m_{m,k}^b - E\left\{b_m^b\right\}\right)$$

$$\text{Eq. 19} \quad \frac{E\left\{C_{bN,k}\right\} E\left\{m_t^N\right\}}{\left\|E\left\{C_{bN,k}\right\} E\left\{m_t^N\right\}\right\|} = \frac{E\left\{(A_{MC})^{-1}\right\} \left(m_{m,k}^b - E\left\{b_m^b\right\}\right)}{\left\|E\left\{(A_{MC})^{-1}\right\} \left(m_{m,k}^b - E\left\{b_m^b\right\}\right)\right\|}$$

$$\text{Eq. 20}\quad E\{C_{bN,k}\}\frac{E\{m_t^N\}}{\left\|E\{m_t^N\}\right\|} = \frac{V_A \Sigma_A^{-1} U_A^T \left(m_{m,k}^b - E\{b_m^b\}\right)}{\left\|V_A \Sigma_A^{-1} U_A^T \left(m_{m,k}^b - E\{b_m^b\}\right)\right\|}$$

The right hand side of equation 20 can be simplified and rewritten as equation 21.

$$\text{Eq. 21}\quad E\{C_{bN,k}\}\frac{E\{m_t^N\}}{\left\|E\{m_t^N\}\right\|} = \begin{bmatrix} V_{A,*1} & V_{A,*2} & V_{A,*3} \end{bmatrix} R_k ,$$

where

$$R_k = \frac{\Sigma_A^{-1} U_A^T \left(m_{m,k}^b - E\{b_m^b\}\right)}{\left\|V_A \Sigma_A^{-1} U_A^T \left(m_{m,k}^b - E\{b_m^b\}\right)\right\|} = \begin{bmatrix} R_{1,k} & R_{2,k} & R_{3,k} \end{bmatrix}^T$$

In equation 21, $V_{A,*1}$, $V_{A,*2}$, $V_{A,*3}$ are the columns of the matrix $V_A$. Based on equation 21, a set of linear equations can be used to solve for $V_A$. An exemplary set of linear equations is shown in matrix form in Eq. 22.

$$\text{Eq. 22}\quad \begin{bmatrix} E\{C_{bN,1}\} & R_{1,1}I_3 & R_{2,1}I_3 & R_{3,1}I_3 \\ \vdots & \vdots & \vdots & \vdots \\ E\{C_{bN,N}\} & R_{1,N}I_3 & R_{2,N}I_3 & R_{3,N}I_3 \end{bmatrix} \begin{bmatrix} \dfrac{E\{m_t^N\}}{\left\|E\{m_t^N\}\right\|} \\ V_{A,*1} \\ V_{A,*2} \\ V_{A,*3} \end{bmatrix} = 0$$

Using the known values discussed above, the set of linear equations can be solved using least squares to determine values of $V_A$ and the local Earth magnetic field vector. Substituting $\beta U_A \Sigma_A V_A^T$ for $E\{A_{MC}\}$ in equation 18 and solving for $\beta$ results in equation 23.

$$\text{Eq. 23}\quad \beta = \pm \frac{\left\|V_A \Sigma_A^{-1} U_A^T \left(m_{m,k}^b - E\{b_m^b\}\right)\right\|}{\left\|E\{m_t^b\}\right\|}$$

Using the solution for $V_A$ and the local Earth magnetic field vector, a value for $\beta$ can be computed. Using the values for $\beta$ and $V_A$, the values for the matrix $A_{MC}$ can be computed. Thus, even without position information and the corresponding data from an Earth magnetic field model, the method 400 provides the ability to calculate the magnetometer calibration parameters.

Figure 5 is a flow chart of an exemplary method 500 of compensating the magnetometer measurements. Method 500 can be implemented at step 212 in method 200. At block 502, the magnetometer measurements are calibrated. For example, an exemplary equation for calibrating the magnetometer measurements is shown in equation 24.

$$\text{Eq. 24} \quad m^{b}_{cal,k} = E\left\{A^{-1}_{MC}\right\}\left(m^{b}_{m,k} - E\left\{b^{b}_{m}\right\}\right)$$

After calibrating the magnetometer measurements, the calibrated measurements are leveled at block 504 to account for orientation of the vehicle. An exemplary equation to level the calibrated measurements is shown in equation 25.

$$\text{Eq. 25} \quad m^{LL}_{cal,k} = E\left\{C_{LLb,k}\right\}m^{b}_{cal,k}$$

In equation 25, $C_{LLb,k}$ is a direction cosine matrix which rotates the calibrated measurements from the body frame to the local level frame. A local level frame is a frame for which two axes are in the tangent plane of the Earth. $C_{LLb,k}$ is a function of the estimated roll angle and pitch angle based on data from gyroscopes 108 in the IMU 104 or the filter 115. After leveling the calibrated measurements, the heading angle is computed at block 506 using the leveled measurements as expressed in equation 26.

$$\text{Eq. 26} \quad \psi_{mag,k} = \tan^{-1}\left(\frac{m^{LL}_{cal,k}(2)}{m^{LL}_{cal,k}(1)}\right)$$

Thus, based on the calibration parameters, method 500 calibrates the magnetometer measurements and compensates the heading angle derived from the magnetometer measurements.

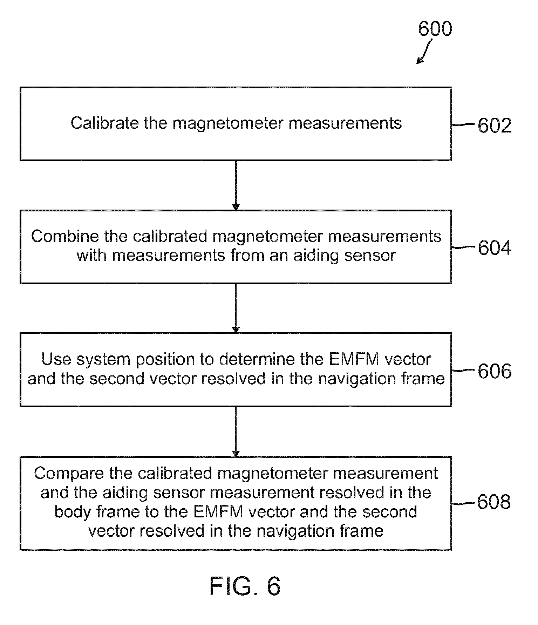

Figure 6 is a flow chart depicting another exemplary method 600 of compensating magnetometer measurements. Method 600 can be implemented in a vector matching procedure to specify the angular orientation of the system. Vector matching refers to comparing the measurements of two vectors in one frame, such as the body frame, to the same two vectors known in a second frame, such as the navigation frame, to specify the angular orientation of the system. A magnetometer and an aiding sensor to measure a second vector can be used in a vector matching procedure. Exemplary aiding sensors can include, but are not limited to, a Sun sensor, star tracker, or monocular camera.

At block 602, the magnetometer measurements are calibrated, as described above with respect to block 502 in method 500. At block 604, the calibrated magnetometer measurements are combined with measurements from an aiding sensor. For example, the magnetometer measurements are combined with the aiding sensor measurements for the two vectors resolved in the body frame. At block 606, the system position is used to determine the EMFM vector and the second vector resolved in the navigation frame. At block 608, the calibrated magnetometer measurement and the aiding sensor measurement are compared to the EMFM vector and the second vector resolved in the navigation frame to specify the three-dimensional angular orientation of the system.

EXAMPLE EMBODIMENTS

Example 1 includes a system comprising: an inertial measurement unit comprising one or more gyroscopes configured to measure angular velocity about a respective one of three independent axes and one or more accelerometers configured to measure specific force along a respective one of the three independent axes; a magnetometer configured to measure strength of a local magnetic field along each of the three independent axes; and a processing device coupled to the inertial measurement unit and the magnetometer; the processing device configured to compute kinematic state data for the system based on measurements received from the magnetometer and the inertial measurement unit; wherein the processing device is further configured to calculate magnetometer measurement calibration parameters using a first technique when position data is unavailable and to calculate magnetometer measurement calibration parameters using a second technique when position data is available.

Example 2 includes the system of Example 1, wherein to calculate magnetometer measurement calibration parameters when position data is unavailable, the processing device is configured to: calculate a hard iron bias vector based on a matrix decomposition of a matrix containing entries based on magnetometer measurements; and calculate at least one of a soft iron bias matrix, a scale factor error matrix, and a misalignment error matrix using the magnetometer measurements and the hard iron bias vector.

Example 3 includes the system of Example 1, wherein to calculate magnetometer measurement calibration parameters when position data is available, the processing device is configured to: determine column rank of a matrix containing estimated magnetic field values obtained from an Earth Magnetic Field Map (EMFM) based on the position data; compute all of the magnetometer measurement calibration parameters for a magnetometer measurement model if the matrix has full column rank; and compute a subset of the magnetometer measurement calibration parameters if the matrix does not have full column rank.

Example 4 includes the system of Example 3, wherein to compute all of the magnetometer measurement calibration parameters when the matrix has full column rank, the processing device is configured to compute all of the magnetometer measurement calibration parameters based on a matrix decomposition of the matrix containing estimated magnetic field values and on the magnetometer measurements from the magnetometer.

Example 5 includes the system of any of Examples 3-4, wherein to determine the column rank of the matrix containing estimated magnetic field values, the processing device is configured to: compute a matrix decomposition of the matrix containing estimated magnetic field values; and compare diagonal values in a diagonal matrix to a user selected threshold, the diagonal matrix obtained from the matrix decomposition of the matrix containing estimated magnetic field values; wherein the column rank is the number of diagonal values that are greater than the user selected threshold, the matrix having full column rank when each of the diagonal values is greater than the user selected threshold.

Example 6 includes the system of any of Examples 3-5, wherein to compute a subset of the magnetometer measurement calibration parameters when the matrix does not have full column rank, the processing device is configured to: apply an affine transformation to a calibration matrix containing variables representing the magnetometer measurement calibration parameters, the affine transformation selecting a linear combination of a subset of variables representing the magnetometer measurement calibration parameters; and compute values for the subset of the magnetometer measurement calibration parameters based on a matrix decomposition of the matrix containing estimated magnetic field values, the magnetometer measurements from the magnetometer, and the affine transformation to the calibration matrix.

Example 7 includes the system of any of Examples 1-6, further comprising at least one aiding sensor configured to provide measurements to the processing device for computing the kinematic state data.

Example 8 includes the system of Example 7, wherein the at least one aiding sensor comprises one or more of an altimeter, camera, global navigation satellite system (GNSS) receiver, Light Detection and Ranging (LIDAR) sensor, Radio Detection and Ranging (RADAR) sensor, star tracker, Sun sensor, and true airspeed sensor.

Example 9 includes the system of any of Examples 1-8, wherein the processing device is configured to calibrate the magnetometer measurements based on the calculated calibration parameters; to level the calibrated magnetometer measurements; and to compensate a calculated heading angle based on the leveled magnetometer measurements.

Example 10 includes a method of calibrating magnetometer measurements, the method comprising: receiving magnetometer measurements from a magnetometer; obtaining attitude and heading measurements based on the magnetometer measurements and on measurements from an inertial measurement unit; determining if position data is available, the position data indicating an approximate geographic location of a system in which the magnetometer is located; when position data is not available, determining magnetometer measurement calibration parameters using a first technique without position data; and when position data is available, determining magnetometer measurement calibration parameters using a second technique based on the position data.

Example 11 includes the method of Example 10, wherein determining magnetometer measurement calibration parameters using the first technique comprises: calculating a hard iron bias vector based on a matrix decomposition of a matrix containing entries based on magnetometer measurements; and calculating at least one of a soft iron bias matrix, a scale factor error matrix, and a misalignment error matrix using the magnetometer measurements and the hard iron bias vector.

Example 12 includes the method of Example 10, wherein determining magnetometer measurement calibration parameters using the second technique comprises: obtaining estimated magnetic field values from an Earth Magnetic Field Map (EFMF) based on the position data; determining column rank of a matrix containing the estimated magnetic field values; computing all of the magnetometer measurement calibration parameters for a magnetometer measurement model if the matrix has full column rank; and computing a subset of the magnetometer measurement calibration parameters if the matrix does not have full column rank.

Example 13 includes the method of Example 12, wherein computing all of the magnetometer measurement calibration parameters when the matrix has full column rank comprises computing all of the magnetometer measurement calibration parameters based on a matrix decomposition of the matrix containing estimated magnetic field values and on the magnetometer measurements from the magnetometer.

Example 14 includes the method of any of Examples 12-13, wherein determining the column rank of the matrix containing estimated magnetic field values comprises: computing a matrix decomposition of the matrix containing estimated magnetic field values; and comparing diagonal values in a diagonal matrix to a user selected threshold, the diagonal matrix obtained from the matrix decomposition of the matrix containing estimated magnetic field values; wherein the column rank is the number of diagonal values that are greater than the user selected threshold, the matrix having full column rank when each of the diagonal values is greater than the user selected threshold.

Example 15 includes the method of any of Examples 12-14, wherein computing a subset of the magnetometer measurement calibration parameters when the matrix does not have full column rank comprises: applying an affine transformation to a calibration matrix containing variables representing the magnetometer measurement calibration parameters, the affine transformation selecting a linear combination of a subset of variables representing the magnetometer measurement calibration parameters; and computing values for the subset of the magnetometer measurement calibration parameters based on a matrix decomposition of the matrix containing estimated magnetic field values, the magnetometer measurements from the magnetometer, and the affine transformation to the calibration matrix.

Example 16 includes a program product comprising a processor-readable medium on which program instructions are embodied, wherein the program instructions are configured, when executed by at least one programmable processor, to cause the at least one programmable processor to: obtain attitude and heading measurements based on magnetometer measurements received from a magnetometer and on inertial measurements received from an inertial measurement unit; determine if position data is available, the position data indicating an approximate geographic location of a system in which the magnetometer is located; when position data is not available, determine magnetometer measurement calibration parameters using a first technique without position data; and when position data is available, determine magnetometer measurement calibration parameters using a second technique based on the position data.

Example 17 includes the program product of Example 16, wherein when position data is not available, the program instructions are further configured to cause the at least one programmable processor to: calculate a hard iron bias vector based on a matrix decomposition of a matrix containing entries based on magnetometer measurements; and calculate at least one of a soft iron bias matrix, a scale factor error matrix, and a misalignment error matrix using the magnetometer measurements and the hard iron bias vector.

Example 18 includes the program product of Example 16, wherein when position data is available, the program instructions are further configured to cause the at least one programmable processor to: obtain estimated magnetic field values from an Earth Magnetic Field Map (EFMF) based on the position data; determine column rank of a matrix containing the estimated magnetic field values; compute all of the magnetometer measurement calibration parameters for a magnetometer measurement model if the matrix has full column rank; and compute a subset of the magnetometer measurement calibration parameters if the matrix does not have full column rank.

Example 19 includes the program product of Example 18, wherein the program instructions are further configured to cause the at least one programmable processor to: compute all of the magnetometer measurement calibration parameters based on a matrix decomposition of the matrix containing estimated magnetic field values and on the magnetometer measurements from the magnetometer when the matrix has full column rank; and when the matrix does not have full column rank: apply an affine transformation to a calibration matrix containing variables representing the magnetometer measurement calibration parameters, the affine transformation selecting a linear combination of a subset of variables representing the magnetometer measurement calibration parameters; and compute values for the subset of the magnetometer measurement calibration parameters based on a matrix decomposition of the matrix containing estimated magnetic field values, the magnetometer measurements from the magnetometer, and the affine transformation to the calibration matrix.

Example 20 includes the program product of any of Examples 18-19, wherein to determine the column rank of the matrix containing estimated magnetic field values, the program instructions are further configured to cause the at least one programmable processor to: compute a matrix decomposition of the matrix containing estimated magnetic field values; and compare diagonal values in a diagonal matrix to a user selected threshold, the diagonal matrix obtained from the matrix decomposition of the matrix containing estimated magnetic field values; wherein the column rank is the number of diagonal values that are greater than the user selected threshold, the matrix having full column rank when each of the diagonal values is greater than the user selected threshold.

Although specific embodiments have been illustrated and described herein, it will be appreciated by those of ordinary skill in the art that any arrangement, which is calculated to achieve the same purpose, may be substituted for the specific embodiments shown. For example, the techniques described herein can be used for calibration and compensation of magnetometer measurements in three dimensions or in two dimensions, as will be apparent to one of skill in the art. Therefore, it is manifestly intended that this invention be limited only by the claims and the equivalents thereof.

**Claims**

1. A system(100) comprising:

   an inertial measurement unit (104) comprising one or more gyroscopes (108) configured to measure angular velocity about a respective one of three independent axes and one or more accelerometers (110) configured to measure specific force along a respective one of the three independent axes;

a magnetometer (102) configured to measure strength of a local magnetic field along each of the three independent axes; and

a processing device (106) coupled to the inertial measurement unit and the magnetometer; the processing device configured to compute kinematic state data for the system based on measurements received from the magnetometer and the inertial measurement unit;

wherein the processing device is further configured to calculate magnetometer measurement calibration parameters using a first technique when position data is unavailable and to calculate magnetometer measurement calibration parameters using a second technique when position data is available.

2. The system of claim 1, wherein to calculate magnetometer measurement calibration parameters when position data is unavailable, the processing device is configured to:

calculate a hard iron bias vector based on a matrix decomposition of a matrix containing entries based on magnetometer measurements; and

calculate at least one of a soft iron bias matrix, a scale factor error matrix, and a misalignment error matrix using the magnetometer measurements and the hard iron bias vector.

3. The system of claim 1, wherein to calculate magnetometer measurement calibration parameters when position data is available, the processing device is configured to:

determine column rank of a matrix containing estimated magnetic field values obtained from an Earth Magnetic Field Map (EMFM) based on the position data;

compute all of the magnetometer measurement calibration parameters for a magnetometer measurement model if the matrix has full column rank; and

compute a subset of the magnetometer measurement calibration parameters if the matrix does not have full column rank.

4. The system of claim 3, wherein to compute all of the magnetometer measurement calibration parameters when the matrix has full column rank, the processing device is configured to compute all of the magnetometer measurement calibration parameters based on a matrix decomposition of the matrix containing estimated magnetic field values and on the magnetometer measurements from the magnetometer.

5. The system of claim 3, wherein to determine the column rank of the matrix containing estimated magnetic field values, the processing device is configured to:

compute a matrix decomposition of the matrix containing estimated magnetic field values; and

compare diagonal values in a diagonal matrix to a user selected threshold, the diagonal matrix obtained from the matrix decomposition of the matrix containing estimated magnetic field values;

wherein the column rank is the number of diagonal values that are greater than the user selected threshold, the matrix having full column rank when each of the diagonal values is greater than the user selected threshold.

6. The system of claim 3, wherein to compute a subset of the magnetometer measurement calibration parameters when the matrix does not have full column rank, the processing device is configured to:

apply an affine transformation to a calibration matrix containing variables representing the magnetometer measurement calibration parameters, the affine transformation selecting a linear combination of a subset of variables representing the magnetometer measurement calibration parameters; and

compute values for the subset of the magnetometer measurement, calibration parameters based on a matrix decomposition of the matrix containing estimated magnetic field values, the magnetometer measurements from the magnetometer, and the affine transformation to the calibration matrix.

7. A method (200) of calibrating magnetometer measurements, the method comprising:

receiving magnetometer measurements from a magnetometer (202);

obtaining attitude and heading measurements based on the magnetometer measurements and on measurements from an inertial measurement unit (204);

determining if position data is available, the position data indicating an approximate geographic location of a system in which the magnetometer is located (206);

when position data is not available, determining magnetometer measurement calibration parameters using a first technique without position data (214); and

when position data is available, determining magnetometer measurement calibration parameters using a second technique based on the position data (208, 210).

8. The method of claim 7, wherein determining magnetometer measurement calibration parameters using the first technique comprises:

calculating a hard iron bias vector based on a matrix decomposition of a matrix containing entries based on magnetometer measurements; and

calculating at least one of a soft iron bias matrix, a scale factor error matrix, and a misalignment error matrix using the magnetometer measurements and the hard iron bias vector.

9. The method of claim 7, wherein determining magnetometer measurement calibration parameters using the second technique comprises:

obtaining estimated magnetic field values from an Earth Magnetic Field Map (EFMF) based on the position data (208);

determining column rank of a matrix containing the estimated magnetic field values (304);

computing all of the magnetometer measurement calibration parameters for a magnetometer measurement model if the matrix has full column rank (306); and

computing a subset of the magnetometer measurement calibration parameters if the matrix does not have full column rank (310).

10. The method of claim 9, wherein computing all of the magnetometer measurement calibration parameters when the matrix has full column rank comprises computing all of the magnetometer measurement calibration parameters based on a matrix decomposition of the matrix containing estimated magnetic field values and on the magnetometer measurements from the magnetometer.

100

IMU 104
Gyro(s) 108
Accel(s) 110

Aiding Sensors (optional) 114

Magnetometer 102

Processing Device 106

Filter 115

Velocity

Angular Orientation

Position

Magnetometer Calibration & Compensation

Memory 112

Calibration & Compensation Instructions 116

Filter Instructions 118

Earth Magnetic Field Model 120

FIG. 1

```
        200
```

Receive magnetometer measurements —202

Obtain attitude and heading
measurements or estimates —204

206
Yes ⟨ Position Available? ⟩ No

208

Obtain Earth magnetic field
for current position

214

Compute calibration parameters
without position information

210

Compute calibration parameters
using the Earth Magnetic
Field Model

212

Compensate magnetometer
measurements based on
computed parameters

FIG. 2

**FIG. 3**

300

302 — Formulate batch model of magnetometer measurement model

304 — Full Rank?

Yes

No

306 — Solve for all of the calibration parameters

308 — Apply affine transformation

310 — Solve for a subset of the calibration parameters using the affine transformation

EP 2 843 434 A2

400

```
┌─────────────────────────────────────────┐
│  Define magnetometer measurement model in │ ──402
│            the body frame                 │
└─────────────────────────────────────────┘
                    │
                    ▼
┌─────────────────────────────────────────┐
│  Rewrite magnetometer measurement model in│ ──404
│             matrix form                   │
└─────────────────────────────────────────┘
                    │
                    ▼
┌─────────────────────────────────────────┐
│  Use least squares to find a solution for P matrix│
│   that is formulated from the magnetometer│ ──406
│          calibration parameters           │
└─────────────────────────────────────────┘
                    │
                    ▼
┌─────────────────────────────────────────┐
│   Calculate an estimate of the hard iron bias │ ──408
└─────────────────────────────────────────┘
                    │
                    ▼
┌─────────────────────────────────────────┐
│ Calculate the soft iron bias, misalignment errors,│
│         and scale factor errors           │ ──410
└─────────────────────────────────────────┘
```

## FIG. 4

500

```
┌─────────────────────────────────────────┐
│   Calibrate the magnetometer measurements │ ──502
└─────────────────────────────────────────┘
                    │
                    ▼
┌─────────────────────────────────────────┐
│ Level the calibrated magnetometer measurements │ ──504
└─────────────────────────────────────────┘
                    │
                    ▼
┌─────────────────────────────────────────┐
│ Compute heading angle using leveled magnetometer │
│             measurements                  │ ──506
└─────────────────────────────────────────┘
```

## FIG. 5

600

Calibrate the magnetometer measurements — 602

Combine the calibrated magnetometer measurements with measurements from an aiding sensor — 604

Use system position to determine the EMFM vector and the second vector resolved in the navigation frame — 606

Compare the calibrated magnetometer measurement and the aiding sensor measurement resolved in the body frame to the EMFM vector and the second vector resolved in the navigation frame — 608

FIG. 6